# EUROPEAN PATENT APPLICATION

(11) **EP 3 324 713 A1**
(43) Date of publication of application: **23.05.2018**
(21) Application number: 17202383.0
(22) Date of filing: 17.11.2017
(51) Int. Cl.: H05K 1/18, H05K 3/12

(54) **A METHOD OF PRODUCING SUPPORT STRUCTURES FOR LIGHTING DEVICES AND CORRESPONDING DEVICE**

(30) Priority: 22.11.2016 IT 201600117983
(71) Applicant: OSRAM GmbH, 80807 München (DE); OSRAM S.P.A. - SOCIETA' RIUNITE OSRAM EDISON CLERICI, 20126 Milano (IT)
(72) Inventor: BALDO, Mr. Lorenzo, I-31040 Giavera del Montello (Treviso) (IT); GRIFFONI, Alessio, I-30030 Fossò (Venezia) (IT)
(74) Representative: Bosotti, Luciano

(57) **Abstract**

Support structures (10), e.g. ribbon-like and flexible support structures, for electrically-powered lighting devices are produced by:
- providing a ribbon-like, electrically insulating substrate (12) having opposed surfaces,
- providing a layout of electrically conductive lines (14) by screen printing electrically conductive ink onto said substrate (12), by screen printing, onto one of the opposite surfaces of the substrate (12), a distribution (141) of electrically conductive lines including repeated patterns (U) of electrically conductive lines, said repeated patterns being separated by separation gaps (G) therebetween, and
- providing electrical continuity between said repeated patterns separated by said separation gaps (G), e.g. by screen printing, onto the same surface of substrate (12), a second distribution of electrically conductive lines (e.g. 142) offset from the first distribution, with the second distribution of electrically conductive lines (142) including repeated patterns (U) of electrically conductive lines extending across the separation gaps (G) between the repeated patterns of the first distribution (141) of electrically conductive lines.

## Description

### Technical Field

The present description relates to lighting devices.

One or more embodiments may refer to lighting devices employing electrically-powered light radiation sources, e.g. solid-state light radiation sources such as LED sources.

### Technological Background

In the field of lighting technology the need is increasingly felt of lighting modules, e.g. LED lighting modules, exhibiting adaptability to the application and usage needs (so-called "customization") with very short development and lead times.

Meeting such requirements is particularly challenging in the context of elongated and flexible (e.g. ribbon-like) LED modules, adapted to be implemented as structures of relevant length carrying a high number of electrical units arranged (e.g. mutually connected in parallel) along the module and including one or more LED chains and the related driving circuitry.

In order to provide electrical continuity and uniform functionality along the whole module length, a possible solution involves the presence of e.g. two or more buses having a certain length.

In order to facilitate the usage of said modules, the customer should be able to cut the module to length at any position between two neighbouring electrical units, so as to obtain a solution adapted to the application and usage needs.

From the point of view of production, it is moreover desirable to implement said modules via reel-to-reel (R2R) processes, so as to obtain rather long continuous modules at reasonable costs.

In order to meet such a need, flexible structures may be used which are laminated ("plated") on one or both sides with conductive materials such as copper or aluminium, and the conductive layers may be engraved according to a desired layout of electrical lines.

If the layout is changed, such a solution requires a virtually complete review of the printed circuit board, which may be a Flexible Printed Circuit Board (FPCB), also requiring an intervention by the board manufacturer. This leads to additional activities and to an associated increase of costs and time.

Another solution may envisage resorting to electrically conductive inks printed on a substrate via techniques such as rotogravure, flexographic printing or offset printing.

Such printing techniques enable the implementation of continuous electrically conductive lines of relevant length. However, these lines are typically thin (e.g. having a thickness lower than 10 micron (1 micron = 10⁻⁶ m)), leading to higher electrical resistance and therefore to a lesser electrical functionality in case of rather long modules.

In this case, again, the electrical layout does not lend itself to easy and rapid customization, because any new layout adaptation may involve relevant modifications in tooling (printing plates).

Another solution envisages the use of conductive inks printed by means of rotary printing. This printing technique enables the production of continuous electrically conductive lines of relevant length. Also in this case, however, the electrical layout cannot be customized in a short time, because any new layout adaptation may involve relevant modifications in tooling.

Moreover, the formulations of the electrically conductive inks to be used in the printing techniques described in the foregoing are not available in a wide range, which is a further obstacle to the employment of such techniques.

### Object and Summary

One or more embodiments aim at overcoming the previously outlined drawbacks.

According to one or more embodiments, said object may be achieved thanks to a method having the features set forth in the claims that follow.

One or more embodiments may also concern a corresponding device.

The claims are an integral part of the technical teaching provided herein with reference to the embodiments.

One or more embodiments may be based on the fact that, in the presently considered context, screen printing is more advantageous than the other printing techniques described in the foregoing.

One or more embodiments may enable, for example, the implementation of a new layout of electrically conductive lines in a short time, as the production and/or the supply of the screens for screen printing may take place in a short time. Moreover, the possibility is given of implementing electrically conductive lines or tracks having a thickness between 5 and 100 micron (1 micron = 10⁻⁶ m), adapted to conduct high currents with low electrical resistance.

Moreover, the range of inks adapted to be used in screen printing is quite wide.

One or more embodiments may moreover be based on the possibility (e.g. in the case of screen printing in a reel-to-reel process) of keeping a given separation gap between two subsequent printed patterns, so as to take into account production tolerances and possible ink smearing.

One or more embodiments lead to the achievement of support structures for lighting devices (e.g. implemented as Flexible Printed Circuit Boards, FPCBs) by using e.g. Polymer Thick Film (PTF) inks embedding electrically conductive (nano)particles, including e.g. silver or copper. Such inks may be screen-printed onto flexible films including e.g. polyimide (PI), polyethylene napthtalate (PEN), polyethyilenimine (PEI), ultra-thin glass, etc., facilitating the achievement of electrical continuity in the electrically conductive lines (e.g. at bus level).

In one or more embodiments, electrical continuity may be supported by the use of electrically conductive bridges (e.g. so-called "zero-Ohm resistors") mounted on the electrical circuit, and/or through electrically conductive vias extending through the base film to connect the opposed sides of the support structure, e.g. by making use of an overlapping area between electrically conductive lines which are formed in offset positions on one or both sides of the support structure.

One or more embodiments may offer one or more of the following advantages:
- possibility of rapidly and economically managing the implementation of new customized products, e.g. involving flexible and linear LED modules, without encountering significant drawbacks e.g. as far as electrical resistance is concerned;
- possibility of introducing changes into the base structure (e.g. FPCB and related layout of the electrically conductive lines/tracks) by the electronic assembler of the electronic circuits, without necessarily involving the supplier of the base structure,

- possibility of managing, on one base structure (e.g. FPCB) different electrical layouts and therefore different electrical circuits,
- possibility of creating flexible and linear LED modules through a reel-to-reel process,
- possibility of using screen printing for said purposes,
- possibility of achieving high flexibility in the implementation of the LED module.

### Brief Description of the Figures

One or more embodiments will now be described, by way of non-limiting example only, with reference to the annexed Figures, wherein:
- Figure 1 exemplifies a principle underlying one or more embodiments,
- Figures 2 to 4 show possible steps for implementing embodiments corresponding to Figure 1,
- Figure 5 exemplifies a principle underlying one or more embodiments,
- Figures 6 and 7 show possible steps for implementing embodiments corresponding to Figure 5,
- Figure 8 exemplifies a principle underlying one or more embodiments,
- Figures 9 to 12, wherein Figure 11 corresponds to a section along line XI-XI of Figure 10, show possible steps for implementing embodiments corresponding to Figure 8.

It will be appreciated that, for simplicity and clarity of illustration, the various Figures may not be drawn to the same scale.

### Detailed Description

In the following description, various specific details are given to provide a thorough understanding of exemplary embodiments of the present description. One or more embodiments may be practiced without one or several specific details, or with other methods, components, materials, etc. In other instances, well-known structures, materials, or operations are not shown or described in detail in order to avoid obscuring various aspects of the embodiments. Reference throughout this specification to "one embodiment" or "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring to the same embodiment. Furthermore, particular features, structures, or characteristics may be combined in any suitable manner in one or more embodiments.

The headings provided herein are for convenience only, and therefore do not interpret the extent of protection or scope of the embodiments.

The Figures generally refer to the production of lighting devices adapted to use electrically- powered light radiation sources L (e.g. solid-state light radiation sources, such as LED sources) arranged on a ribbon-like, optionally flexible support structure 10.

As far as the present disclosure is concerned, said structure 10 may be considered as having an indefinite length, whereof a portion is shown in the Figures.

One or more embodiments may offer the possibility of subdividing structure 10 into segments, i.e. of cutting it to length depending on the application and usage needs.

In one or more embodiments, structure 10 may include a ribbon-like substrate 12, e.g. made of an electrically insulating material, which is substantially similar to a substrate for Flexible Printed Circuit Boards (FPCB).

In one or more embodiments, substrate 12 may include a material such as polyimide (PI), polyethylene napthtalate (PEN), polyethyilenimine (PEI), ultra-thin glass, etc., onto which, optionally via a reel-to-reel (R2R) process, a layout of electrically conductive lines 14 may be formed by screen printing.

In one or more embodiments, screen printing may make use of electrically conductive ink (e.g. a polymer ink for thick film printing (Polymer Thick Film, PTF)) containing a dispersion of electrically conductive material such as e.g. (nano)particles of silver and/copper.

In one or more embodiments, electrically conductive lines 14 may include both lines extending continuously along the length of structure 10 (e.g. serving as a bus) and lines or pad adapted to perform a function of local electrical conductivity for light radiation sources L.

In one or more embodiments, sources L (e.g. LED sources) may be mounted onto structure 10 by resorting to known mounting techniques (e.g. SMT technology).

Moreover, the annexed Figures refer - by way of example only, and therefore without limiting the embodiments - to a process aiming at implementing, within ribbon-like structure 10, a certain number of ribbon-like modules 10₁, 10_{2, ...,} 10₆ (the reference to six modules is merely exemplary, given that said modules may be present in any number, ideally from 1 to N), initially formed as a single structure and destined to be subsequently separated - according to known methods - so as to originate single ribbon-like modules which may be used for the implementation of respective LED modules.

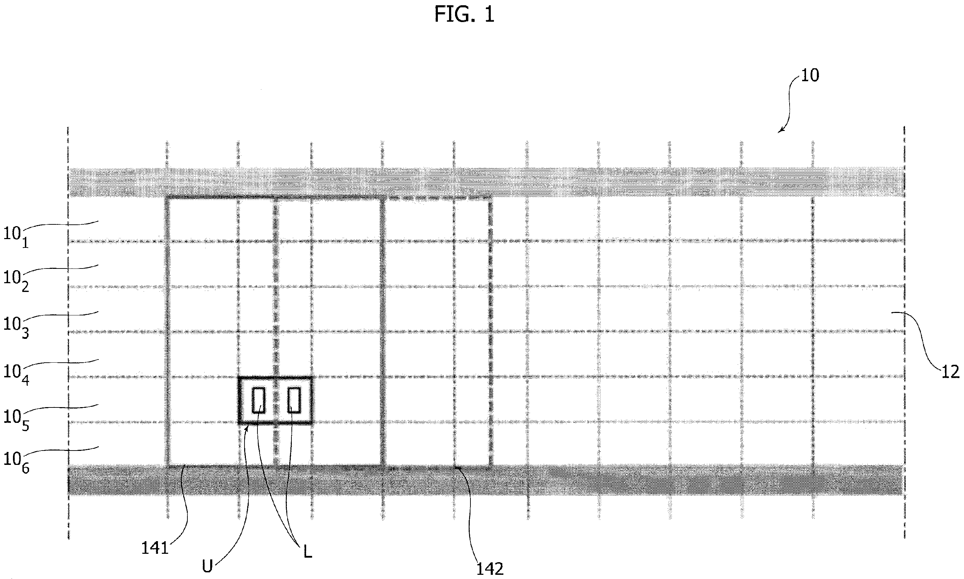

In order not to overburden the graphical representation, the possible presence of modules 10₁, 10_{2, ...,} 10₆ is explicitly shown only in Figures 1, 5 and 8, which illustrate the principle underlying one or more embodiments.

In the following, the present description will therefore refer to structure 10 as a whole, it being understood that the operations exemplified with reference to structure 10 are adapted to be carried out onto all and each of modules 10₁, 10_{2, ...,} 10₆ included therein.

Moreover, in one or more embodiments, the distribution of electrically conductive tracks or lines 14 may be considered as organized in single electrical units U, each of which may be destined to host a respective group of (one or more) light radiation source(s) L, optionally having respective drivers or supply devices associated thereto.

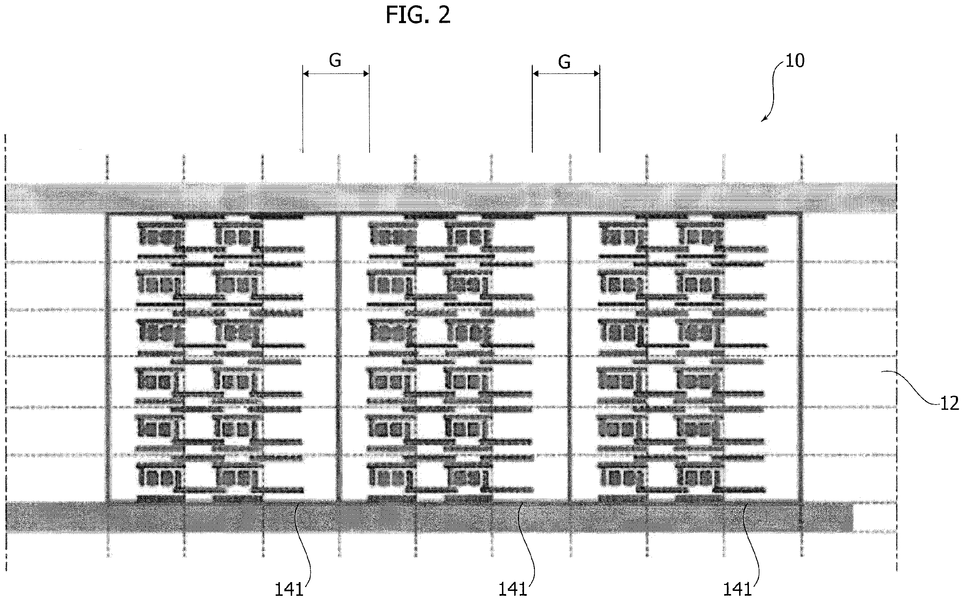

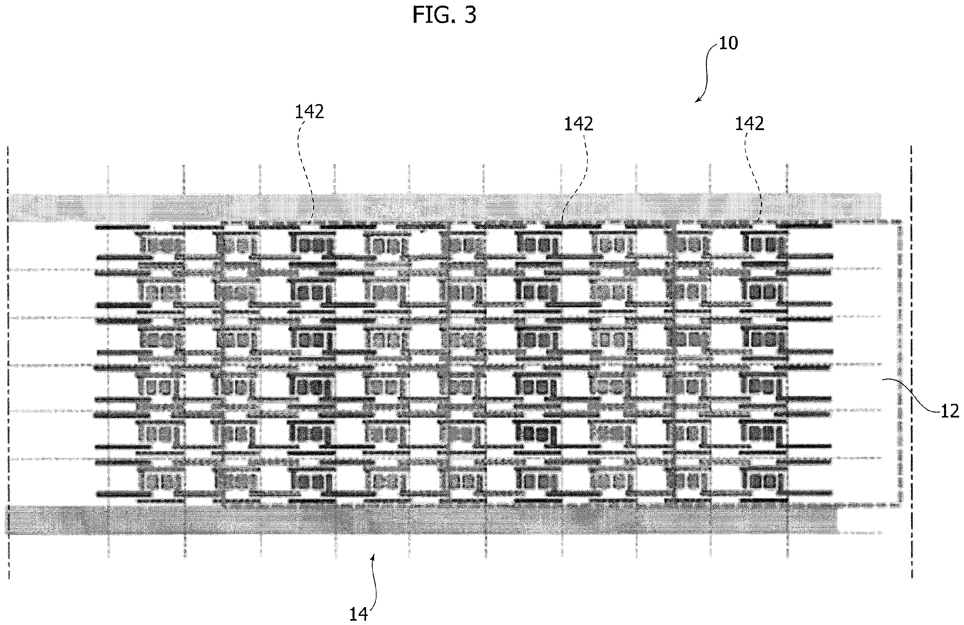

In one or more embodiments as exemplified in Figures 1 to 4, the screen printing of the ink of electrically conductive lines 14 onto substrate 12 involves two successive printing steps, both carried out on the same face or surface of substrate 12 and ideally shown in Figures 2 and 3, with:
- printing a first distribution 141 of electrically conductive lines onto substrate 12;
- printing a second distribution 142 of electrically conductive lines onto substrate 12, while placing it offset from the first in the lengthwise direction of substrate 12.

Such a procedure is schematically shown in Figure 1, wherein the area surrounded by a continuous line, denoted as 141, and the area surrounded by a dashed line, denoted as 142, show two (adjoining and partially overlapping) areas for the execution of both screen printing operations, which are carried out being mutually offset longitudinally of substrate 12.

In one or more embodiments, the printing areas 141 and 142 (the patterns whereof are repeated, e.g. with constant pitch, lengthwise of support 12) may be chosen according to a criterion which may be appreciated by observing Figure 2 and then Figure 3.

Indeed, Figure 2 shows that the printing in areas 141, each of which includes a given number of electrical units U aligned transversally of substrate 12, is carried out while leaving a certain separation gap G between successive areas 141.

In one or more embodiments, such a procedure facilitates avoiding possible drawbacks due to tolerances and to possible smearing of the electrically conductive ink during the screen printing process.

Once the first distribution of the electrically conductive lines has been carried out in the areas denoted as 141, in the second screen printing operation (exemplified in Figure 3) the printing may be carried out of a further distribution of units U in areas 142, which (as may be appreciated from Figures 2 and 3) are offset from areas 141 and extend at the gaps G between the units U of the first distribution (rectangles 141), overlapping the latter at least at the edges.

This enables the achievement of a relationship of continuous connection along the lengthwise direction of structure 10 (i.e. along the modules 10_{1,... . .,} 10₆ included therein).

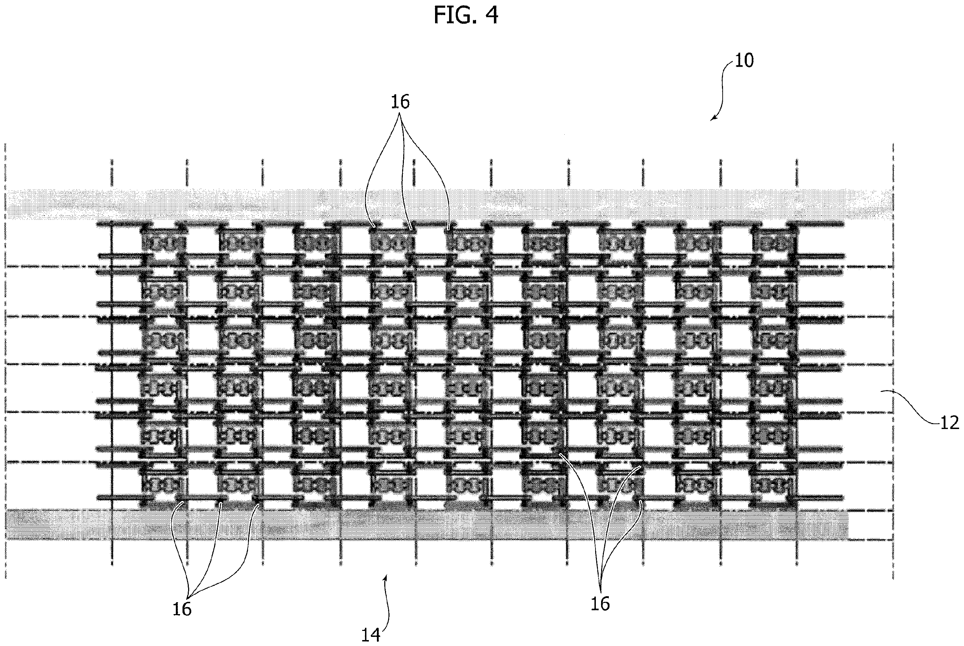

As exemplified in Figure 4, this relationship of continuous electrical connection lengthwise of structure 10 may be supported by electrically conductive bridges 16, which may optionally be applied in a distribution which may be chosen, and optionally modified, in such a way as to implement different electrical connection layouts, according to the application and usage needs.

In one or more embodiments, said electrically conductive bridges 16 may include e.g. zero-Ohm SMT components.

In one or more embodiments, the application of bridges 16 may be carried out simultaneously with the application, on support structure 10, of sources L (e.g. LED sources) and optionally of other electrical and electronic components (e.g. LED drivers, resistors, etc.), which is again adapted to be implemented via SMT technology.

The operations leading to the implementation of both distributions of electrically conductive lines, corresponding to the areas denoted as 141 and 142, may be performed on a structure 10 which may be wound onto a roll or reel in a reel-to-reel process.

For example, such operations may be performed at different times, e.g. by printing the (first) distribution of areas 141 along the whole length of the reel, which is then processed a second time in order to print the (second) distribution of areas 142, once again along the whole length of the reel. This may take place, for example, after hardening (e.g. curing) the conductive ink of the first distribution 141, the second distribution of lines 142 being screen printed along the length of the reel with optional subsequent curing of the electrically conductive ink.

In one or more embodiments, the curing may be carried out in both cases in an oven unit located downstream the screen printing station.

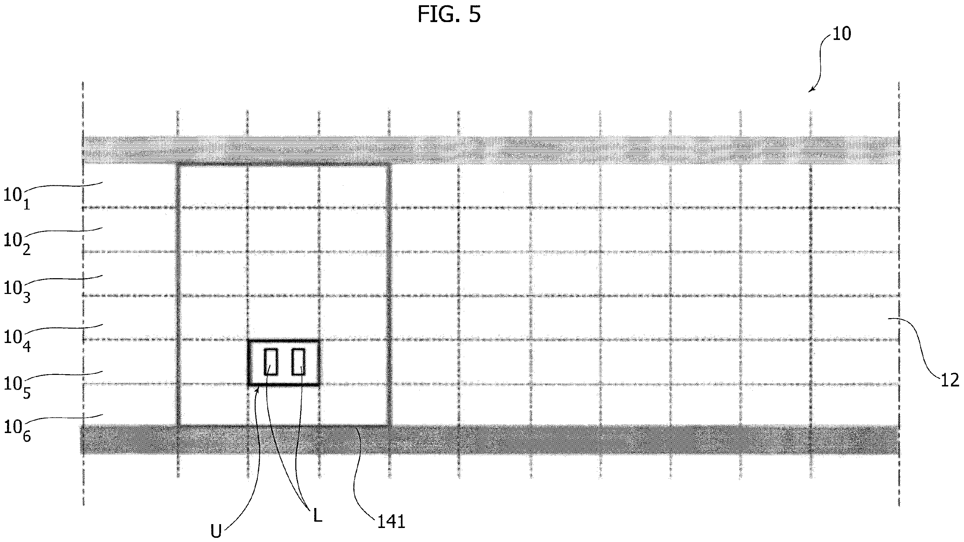

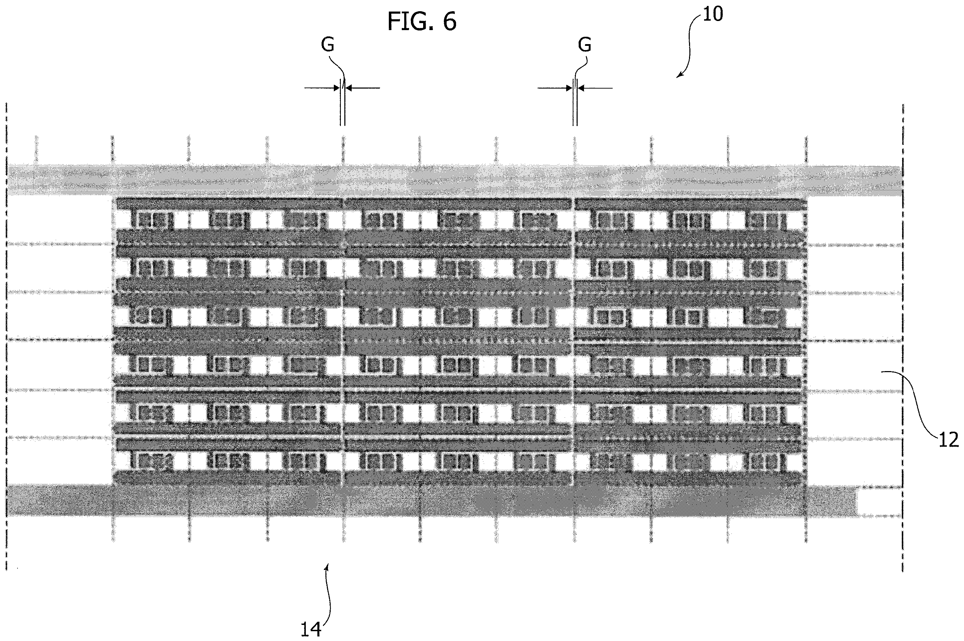

One or more embodiments as exemplified in Figures 5 to 7 envisage the execution, on substrate 12, of one screen printing operation, substantially similar to what has been exemplified in Figure 2, the difference being that such an operation is performed, as exemplified in Figure 6, by carrying out one single distribution 141 of electrically conductive lines, while keeping the separation gaps G small (virtually minimized, while taking into account the tolerance parameters and the possible ink smearing).

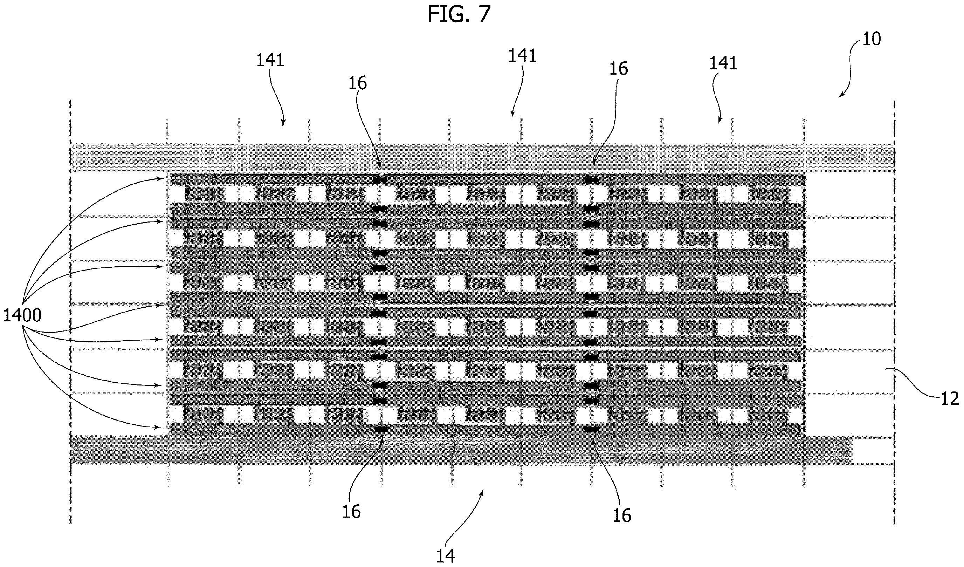

As exemplified in Figure 7, the lengthwise connection between the various exposure areas 141, which imparts a lengthwise continuity (e.g. as regards bus lines 1400) between units U, may be achieved once again by using electrically conductive bridges 16.

Also in this case, bridges 16 may be SMT components, adapted to be mounted onto substrate 12 according to a method substantially corresponding to the procedure adopted for mounting light radiation sources L and the electrical/electronic components optionally associated thereto, the possibility being therefore given of mounting bridges 16 and light radiation sources L (and the optional electrical/electronic components associated thereto) at the same time.

In this case, the screen printing operation may again be carried out along the whole length of a reel in a reel-to-reel process, with optional curing of the electrically conductive ink after the printing process (which may be implemented e.g. in an oven unit located downstream the screen printing station).

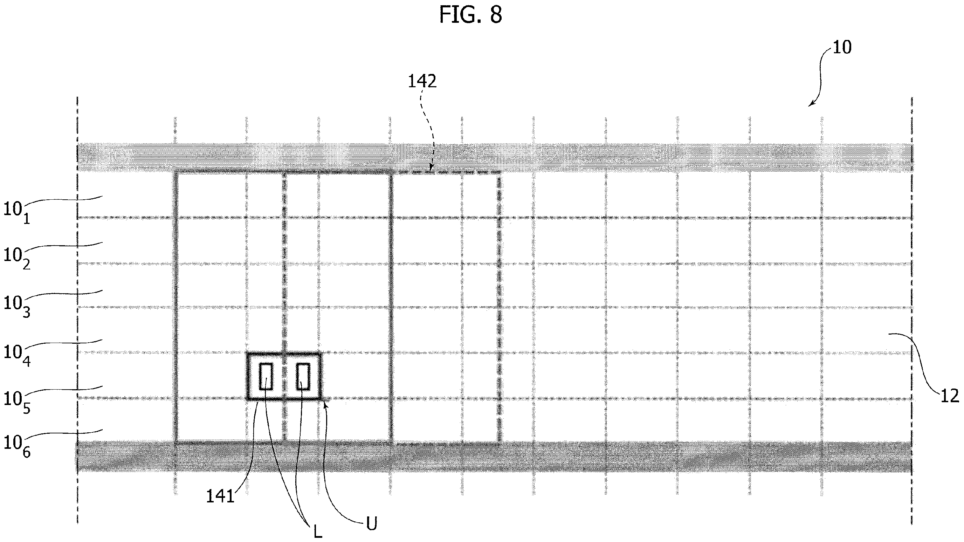

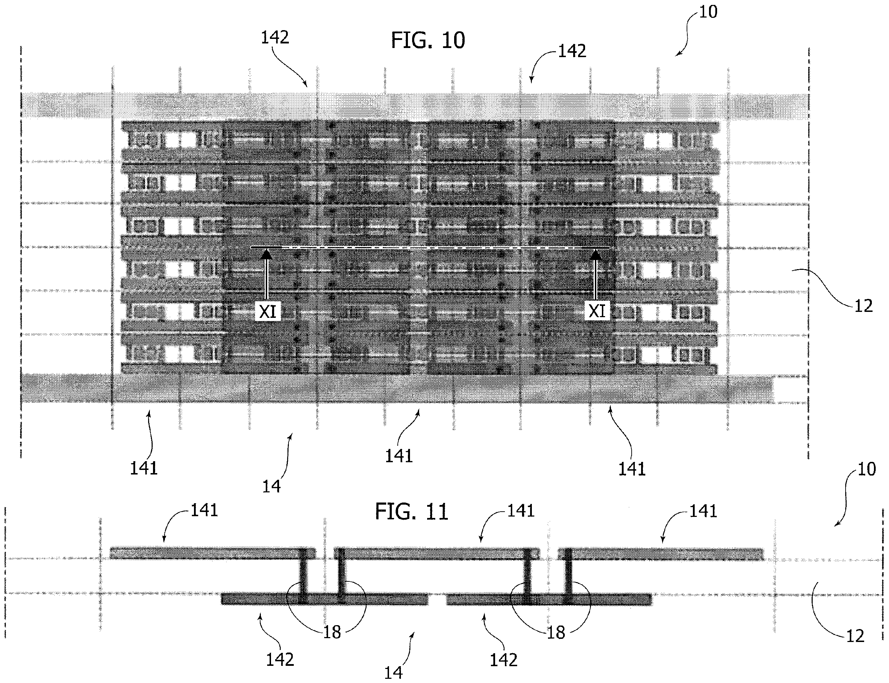

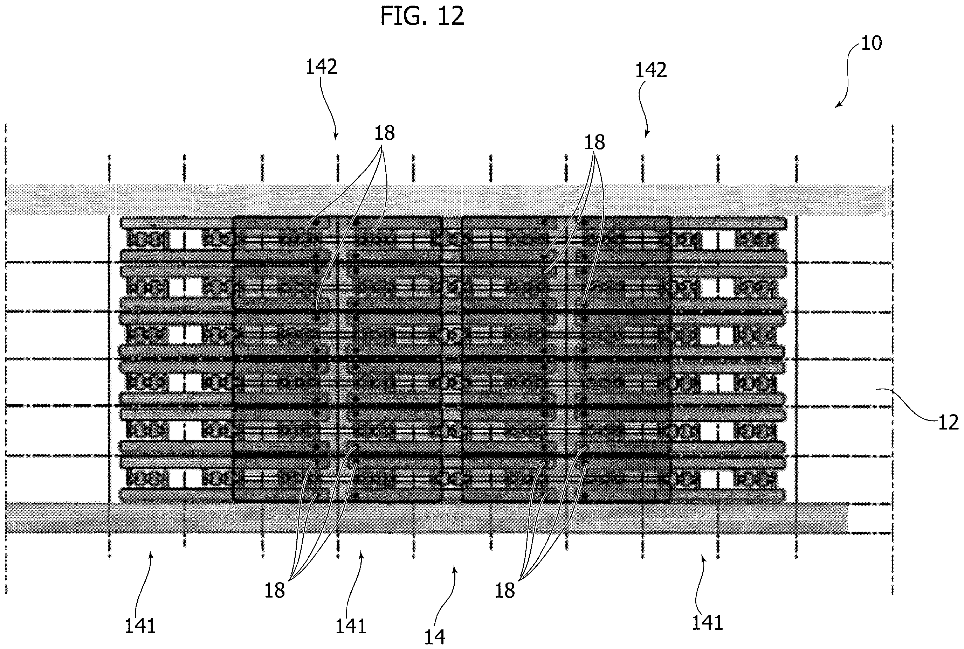

One or more embodiments as exemplified in Figures 8 to 12 may be partly based on the same principle as exemplified in Figures 1 to 4 (with exposure areas or regions 141, 142 offset longitudinally of structure 10), the difference being that, in one or more embodiments as exemplified in Figures 8 to 12, the distributions of the electrically conductive lines 141, 142 are respectively implemented on opposed faces of substrate 12 (see e.g. the cross-section view in Figure 11).

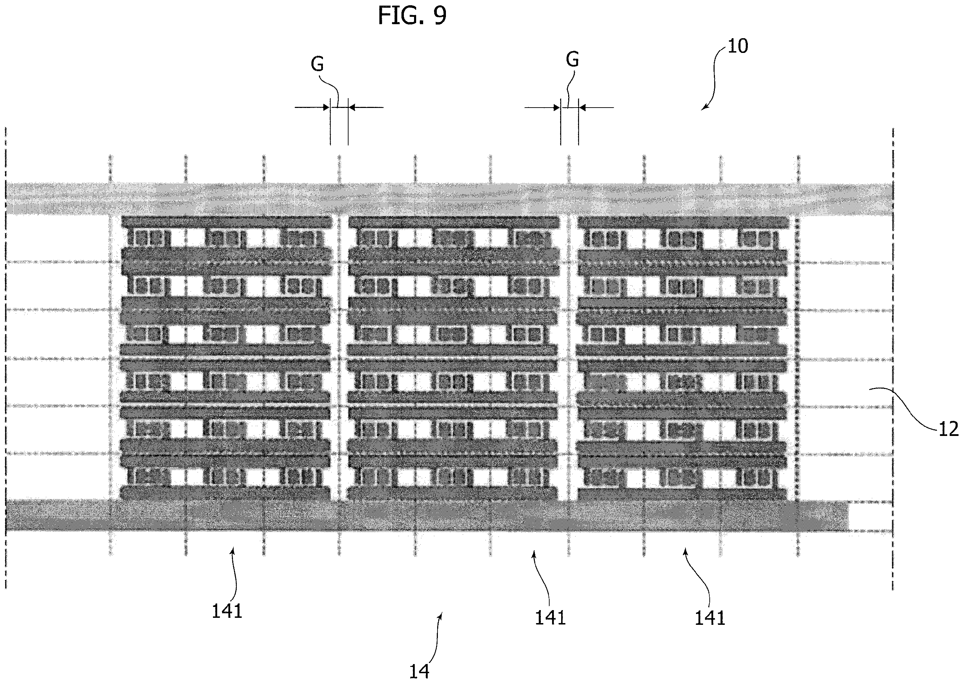

Moreover, the possibility is given of using, in the printing of the first distribution 141 (see e.g. Figure 9), separation gaps G which are smaller than in the embodiments exemplified in Figures 1 to 4.

In one or more embodiments as exemplified in Figures 8 to 12, the connection between both distributions 141 and 142 on both faces of substrate 12 may be implemented through electrically conductive vias 18 which run through substrate 12 according to known criteria, e.g. with an optional filling and capping treatment being selectively performed at the positions wherein a selective electrical connection is desired (both as regards the bus lines extending lengthwise of structure 10 and as regards the local connections within units U), according to the application and usage needs.

In this case, the printing processes for implementing the distributions 141, 142 may be executed either in succession or at the same time, as each printing operation may be carried out along the whole length of the reel in a reel-to-reel process, with a possible ink curing as described in the foregoing.

In one or more embodiments, also the electrically conductive vias 18 may be obtained via a printing process carried out along the whole length of the reel in the reel-to-reel process, optionally in coordination with mounting the light radiation sources L and the electrical/electronic components optionally associated thereto.

One or more embodiments may offer good flexibility also as regards the ability to adapt to the specific application and usage needs ("customization"), thanks to the possibility of acting on distributions 141, 142 both as regards printing - the possibility being given to change the printing layout by modifying the screen printing plates rapidly and economically, and as regards the choice of the mounting/forming of electrically conductive bridges 16 or electrically conductive vias 18.

It will be appreciated, moreover, that the features and/or elements presently described with reference to embodiments exemplified in one of the annexed Figures may optionally be applied, alone or in combination, to other embodiments exemplified in other annexed Figures.

One or more embodiments may therefore provide a method of producing support structures (e.g. 10) for electrically-powered lighting devices, the method including:
- providing a ribbon-like, electrically insulating substrate (e.g. 12) having opposed surfaces,
- providing a layout of electrically conductive lines (e.g. 14) by screen printing electrically conductive ink onto said substrate, said screen printing including screen printing, onto one of said opposite surfaces of the substrate, a first distribution (e.g. 141) of electrically conductive lines including repeated patterns (U) of electrically conductive lines, said repeated patterns being separated by separation gaps (e.g. G) therebetween, and
- providing electrical continuity between said repeated patterns separated by separation gaps.

In one or more embodiments, providing electrical continuity may include (see for example Figures 3 and 4) screen printing, onto said one of said opposite surfaces, a second distribution of electrically conductive lines (e.g. 142) offset from said first distribution of electrically conductive lines along said substrate, with said second distribution of electrically conductive lines (142) including repeated patterns of electrically conductive lines extending across said separation gaps between the repeated patterns of said first distribution of electrically conductive lines.

In one or more embodiments, providing electrical continuity may include (see e.g. Figures 4 or 7) applying electrically-conductive bridges (e.g. 16) extending across said separation gaps between the patterns of said first distribution of electrically conductive lines.

In one or more embodiments, said electrically-conductive bridges may include zero-Ohm SMT components.

In one or more embodiments, said providing electrical continuity may include (see e.g. Figures 10 to 12):
- screen printing, on the other of the opposite faces of said substrate, a second distribution of electrically conductive lines (e.g. 142) extending at said gaps between the repeated patterns in said first distribution of electrically conductive lines, and
- providing electrically conductive vias (e.g. 18) extending through said electrically insulating substrate between said first distribution and said second distribution of electrically conductive lines.

One or more embodiments may include curing said electrically-conductive ink after screen printing onto said electrically insulating substrate.

One or more embodiments may include providing said ribbon-like substrate as a reel, and screen printing said electrically conductive ink onto said reel of ribbon-like substrate in a reel-to-reel process.

One or more embodiments may include subdividing said support structure into a plurality of ribbon-like modules (e.g. 10_{1,.....,} 10₆) co-extensive along the length of said support structure.

In one or more embodiments, a lighting device may include:
- a support structure produced according to one or more embodiments, and
- electrically-powered light radiation sources (e.g. L) arranged on said support structure, with said electrically-powered light radiation sources electrically coupled with said layout of electrically conductive lines.

In one or more embodiments:
- said electrically-powered light radiation sources may include LED sources (L), and/or
- said electrically-powered light radiation sources may be mounted onto said support structure via SMT technology.

Without prejudice to the basic principles, the implementation details and the embodiments may vary, even appreciably, with respect to what has been described herein by way of non-limiting example only, without departing from the extent of protection.

The extent of protection is defined by the annexed claims.

## Claims

1. A method of producing support structures (10) for electrically-powered lighting devices, the method including:
- providing a ribbon-like, electrically insulating substrate (12) having opposed surfaces,
- providing a layout of electrically conductive lines (14) by screen-printing electrically conductive ink onto said substrate (12), wherein said screen-printing includes screen-printing onto one of said opposite surfaces of the substrate (12) a first distribution of electrically conductive lines including repeated patterns (U) of electrically conductive lines (141), said repeated patterns being separated by separation gaps (G) therebetween, and
- providing electrical continuity (142, 16, 18) between said repeated patterns (U) separated by said separation gaps (G).

2. The method of claim 1, wherein providing electrical continuity includes screen printing onto said one of said opposite surfaces a second distribution of electrically conductive lines (142) offset longitudinally of said ribbon-like substrate (12) with respect to said first distribution of electrically conductive lines (141), wherein said second distribution of electrically conductive lines (142) includes repeated patterns (U) of electrically conductive lines extending across said separation gaps (G) in said first distribution of electrically conductive lines (141).

3. The method of claim 1 or claim 2, wherein providing electrical continuity includes applying electrically-conductive bridges (16) extending across said separation gaps (G).

4. The method of claim 3, wherein said electrically-conductive bridges (16) include zero-Ohm SMT components.

5. The method of claim 1, wherein providing electrical continuity includes:
- screen-printing on the other of said opposite surfaces of said substrate (12) a second distribution of electrically conductive lines (142) extending across said gaps (G) in said first distribution of electrically conductive lines (141),
- providing electrically conductive vias (18) extending through said electrically insulating substrate (12) between said first distribution (141) and said second distribution (142) of electrically conductive lines.

6. The method of any of the previous claims, including curing said electrically-conductive ink after screen-printing onto said electrically insulating substrate (12).

7. The method of any of the previous claims, including providing said ribbon-like substrate (12) as a reel and screen printing said electrically conductive ink onto said reel of ribbon-like substrate in a reel-to-reel process.

8. The method of any of the previous claims, including subdividing said support structure (10) into a plurality of ribbon-like modules (10_{1,.....,} 10₆) co-extensive along the length of said support structure (10).

9. A lighting device, including:
- a support structure (10) produced with the method of any of claims 1 to 8, and
- electrically-powered light radiation sources (L) arranged on said support structure (10) said electrically-powered light radiation sources coupled with said layout of electrically conductive lines (14).

10. The lighting device of claim 9, wherein:
- said electrically-powered light radiation sources include LED sources (L), and/or
- said electrically-powered light radiation sources (L) are mounted onto said substrate (10) via SMT technology.
